# NEUE EUROPÄISCHE PATENTSCHRIFT

(11) **EP 0 218 042 B2**
(45) Veröffentlichungstag und Bekanntmachung des Hinweises auf die Entscheidung über den Einspruch: **15.05.1996**
(45) Hinweis auf die Patenterteilung: 03.01.1990
(21) Anmeldenummer: 86111035.1
(22) Anmeldetag: 09.08.1986
(51) Int. Cl.: H03K 17/95

(54) **Magnetfeldabhängiger, elektronischer Annäherungsschalter**
Magnetic-field-dependent electronic proximity switch
Commutateur de proximité électronique dépendant d'un champ magnétique

(30) Priorität: 02.10.1985 DE 3535123; 18.12.1985 DE 3544809
(43) Veröffentlichungstag der Anmeldung: 15.04.1987
(73) Patentinhaber: Werner Turck GmbH & Co. KG, D-58553 Halver (DE)
(72) Erfinder: Nest, Andreas, Dr.-Ing. Dipl.-Phys., D-4690 Herne 1 (DE); Müller, Jens, D-5608 Radevormwald (DE)
(74) Vertreter: Peerbooms, Rudolf, Dipl.-Phys.

(56) Entgegenhaltungen:
- WO-A-86/07637
- DE-A- 1 762 565
- DE-A- 2 920 084
- DE-A- 3 122 949
- DE-A- 3 521 816
- DE-B- 1 175 327
- DE-B- 2 063 416
- DE-C- 3 318 270
- "Neue Sensoren"; Veröffentlichung der Daimler-Benz AG,1984

## Beschreibung

### Beschreibung für folgende Vertragsstaaten : AT, BE, IT

Die Erfindung betrifft einen magnetfeldabhängigen, elektronischen Annäherungsschater, welcher durch einen sich annähernden, magnetischen Auslöser betätigt wird, mit einem durch den Auslöser beeinflußbaren HF-Schwingkreis einer Oszillatorschaltung, deren eine Schwingkreisspule und eine Kopplungsspule aufweisender Spulenanordnung ein magnetischer Körper zugeordnet ist, welcher ab einer bestimmten Magnetfeldstärke durch das äußere Magnetfeld des Auslösers unter Entdämpfung des Schwingkreises in magnetische Sättigung treibbar ist.

Durch die DE-AS 11 75 327 ist ein Annäherungsschalter mit einer Oszillatorschaltung bekannt, bei welchen zwischen der Schwingkreisspule und der Rückkopplungsspule eine permeable Metallplatte angeordnet ist. Durch diese Metallplatte wird die Schwingkreisspule weitgehend gegenüber der Kopplungsspule abgeschirmt, so daß nur stark gedämpfte Schwingungen auftreten. Durch Annäherung eines permanentmagnetischen Auslösers kann die dortige Metallplatte in Sättigung getrieben werden, wodurch deren Abschirmwirkung sprungartig reduziert wird und sich somit eine deutliche Entdämpfung des Schwingkreises ergibt. Dieser Effekt wird zur Betätigung eines elektronischen Schalters genutzt. Da der Schwingkreis im Grundzustand stark bedämpft ist, also kein Ausgangssignal liefert, können Fehler in der elektronischen Schaltung, die immer zu einem Abreißen des Signales, nicht aber zu einer Anfachung führen, nicht in irrtümlicher Weise in ein Schaltsignal umgesetzt werden. Der bekannte Annäherungsschalter besitzt allerdings im Verhältnis zu seiner Baugröße eine geringe Ansprechempfindlichkeit, weshalb er bei kleiner Ausbildung - etwa mit nur einem Kubikzentimeter Raumbedarf - nicht durch nicht - permeable Metallwände hindurch, z. B. aus Aluminium oder aus austenitischem Stahl ausgelöst werden kann.

Der Erfindung liegt die Aufgabe zugrunde, einen gattungsgemäßen Annäherungsschalter zu schaffen, welcher bei geringer Baugröße eine hohe Ansprechempfindlichkeit aufweist.

Diese Aufgabe ist erfindungsgemäß dadurch gelöst, daß der magnetisierbare Körper aus einem amorphen oder überwiegend amorphen Metallband besteht und daß die Schwingkreisspule und die Kopplungsspule auf einem gemeinsamen Wickelkörper sitzen. Amorphes Metall, welches in der amerikanischen Literatur auch als metallisches Glas bezeichnet wird und welches im deutschen Bereich unter dem geschützten Warenzeichen "Vitrovac" vertrieben wird, ist ein Material, welches eine hohe Permeabilität aufweist, dessen elektrische Leitfähigkeit aber im Vergleich zu Transformator- oder Dynamoblechen gering ist. Bei der erfindungsgemäßen Anordnung ist der Schwingkreis im Grundzustand stark bedämpft und wird durch einen sich annähernden magnetischen Auslöser sprunghaft zu starken Schwingungen angeregt, wobei auch bei einer geringen Baugröße eine sehr hohe Ansprechempfindlichkeit gegeben ist. Da die Schwingkreisspule und die Kopplungsspule auf einem gemeinsamen Wickelkörper sitzen, beeinflußt der magnetische Auslöser allerdings nicht bzw. nur unmaßgeblich das Kopplungsverhalten zwischen den beiden Spulen. Entscheidend ist offenbar - trotz der relativ niedrigen elektrischen Leitfähigkeit des amorphen Metallbandes - die Induktion von sehr starken Wirbelströmen im amorphen Metallband. Das Metallband scheint im Grundzustand aufgrund seiner hohen Permeabilität das HF-Schwingkreisfeld so eng an sich zu binden, daß es zu großen Wirbelstromverlusten kommt. Bei Annäherung eines Auslösers wird auch dessen Magnetfeld in besonderer Weise von dem amorphen Metallband angezogen, so daß es schnell in Sättigung getrieben wird. Die in der Praxis beobachtete, starke Entdämpfung des Schwingkreises ist jedoch überraschend, da bei einer Abnahme der Permeabilität des amorphen Metallbandes die Induktivität des Schwingkreises absinken und die Resonanzfrequenz somit ansteigen müßte, wonach eigentlich mit einer Erhöhung der Wirbelstromverluste zu rechnen wäre. In jedem Falle ist in der Praxis ein sehr ausgeprägtes Umschlagen des Dämpfungszustandes festzustellen. Weitere Vorteile bei der Verwendung eines amorphen Metallbandes sind die guten zähelastischen Eigenschaften, die den Annäherungsschalter insbesondere gegenüber Erschütterungen und Stoß unempfindlich machen, sowie die Unabhängigkeit der Kennwerte gegenüber Temperaturschwankungen, die einen Einsatz des Sensorkopfes zwischen -50° C und +150° C ohne einen Temperaturausgleich erlauben.

Der Erfindung zufolge kann das amorphe Metallband als geradliniger, dünner Streifen ausgebildet sein, welcher auf der Achse der Spulenanordnung angeordnet ist und den Spulentorus durchsetzt. Mit dieser Ausg estaltung lassen sich sehr hohe Ansprechempfindlichkeiten erzielen, die mit zunehmender Länge des amorphen Metallbandes ansteigen. Schon bei einer Bandlänge von etwa einem Zentimeter lassen sich Ansprechabstände von etwa zehn Zentimetern erreichen.

Nach einer bevorzugten Ausführungsform des Annäherungsschalters, welcher vorzugsweise durch einen sich am Annäherungsschalter entlang bewegenden Auslöser betätigt wird, kann gemäß der Erfindung das amorphe Metallband die Form eines in sich geschlossenen Ringes oder Ovals besitzen, wobei der Ring bzw. das Oval die Spulenachse durchsetzt und den Spulentorus umschlingt. Bei üblichen Annäherungsschaltern, beispielsweise Reed-Kontakten, besteht das Problem, daß es bei einer Bewegung des Auslösers entlang des Annäherungsschalters zu Mehrfach-Auslösungen kommen kann. Durch die Ausbildung des amorphen Metallbandes in Form eines in sich geschlossenen Ringes oder Ovals kommt es dagegen beim Vorbeiführen des Auslösers nur zu einem einzigen Schaltvorgang. Bei einer solchen Querbewegung des Auslösers ist im übrigen die Schaltzone eng begrenzt, so daß eine sehr genaue Positonserfassung des Auslösers gewährleistet ist. Durch eine einfache Verformung des ringförmigen Metallbandes lassen sich im übrigen innerhalb gewisser Grenzen die Kenndaten des Annäherungsschalters beeinflussen. Dabei erweist es sich als vorteilhaft, daß das amorphe Metallband durch Biegen oder dgl. Verformungen keine Änderung seiner magnetischen Eigenschaft erfährt.

In weiterer Ausgestaltung der Erfindung können zwei oder mehrere in sich geschlossene, ringförmige oder ovale Metallbänder vorgesehen sein, die längs des Spulentorus verteilt sind. Auch durch die Anordnung von mehreren Metallbandringen lassen sich die Kenndaten eines Annäherungsschalters beeinflussen. Vorteilhaft ist insbesondere eine Vergrößerung des Ansprechbereiches bei einer Bewegung des Auslösers auf den Annäherungsschalter zu, während hinsichtlich einer Querbewegung des Auslösers die Ansprechzone weiterhin sehr schmal bleibt.

Der Erfindung zufolge kann das Metallband eine Stärke zwischen 15 bis 50 µ, vorzugsweise 30 µ, und eine Breite von zwei bis drei Millimetern besitzen. Weiterhin kann gemäß der Erfindung der Ringdurchmesser in der Größenordnung von zwei bis zehn Millimetern liegen. Schon bei diesen geringen Baugrößen lassen sich sehr hohe Ansprechempfindlichkeiten erzielen.

Gemäß einer bevorzugten Ausführungsform der Erfindung ist das amorphe Metallband als ein U- oder C-förmiges Bogenstück ausgebildet, dessen Öffnung an der Ansprechseite des Annäherungsschalters liegt. Bei der bevorzugten Ausführungsform ergibt sich eine sehr schmale, weit ragende, parabelförmige Ansprechzone, wobei insbesondere Nebenansprechzonen vermieden sind. Ein solcher Annäherungsschalter ist für die unterschiedlichsten Empfindlichkeitsbereiche einsetzbar und erübrigt die Bereithaltung verschiedener Typen. Der Rücken des Bogenstückes liegt dabei vorteilhafterweise im Spulentorus, wodurch sich eine exakt symmetrische Ansprechzone ergibt.

Nach weiteren Merkmalen der Erfindung kann die Weite der Bogenstücköffnung etwa gleich oder kleiner als die axiale Abmessung des Spulentorus sein. Eine fertigungstechnisch besonders günstige Ausführungsform ergibt sich bei einer ringförmigen Ausbildung des Bogenstückes und bei einer Ringöffnungsweite, die etwa gleich oder kleiner als der Radius des Bogenstückes ist. Bei einem Radius von etwa 3 Millimetern des ringförmigen Bogenstückes beträgt die Öffnungsweite etwa 2,5 Millimeter.

Gemäß einer alternativen Ausführungsform kann der Erfindung zufolge vorgesehen werden, daß der Rücken des Bogenstückes an der der Ansprechseite gegenüberliegenden Stimseite des Spulentorus liegt und daß das Bogenstück mit seinen Seitenschenkeln eine Torusfhälfte umgreift.

Die Erfindung wird im folgenden anhand der Zeichnung näher erläutert. Es zeigen:
Fig. 1 ein Prinzipschaltbild eines Annäherungsschalters gemäß einer ersten Ausführungsform,
Fig. 2 eine alternative Ausführungsform eines Oszillatorteils des Annäherungschalters in einer Blockbilddarstellung,
Fig. 3 die Spulenanordnung des Oszillatorteils nach Fig. 2 mit einem geradlinigen, amorphen Metallband in perspektivischer Darstellung,
Fig. 4 die Spulenanordnung des Oszillatorteils nach Fig. 1 mit einem ringförmigen, amorphen Metallband in perspektivischer Darstellung,
Fig. 5 den aus Spulenanordnung und ringförmigem Metallband bestehenden Sensorkopf gemäß einer Blickrichtung V in Fig. 4,
Fig. 6 eine alternative Ausführungsform eines Sensorkopfes mit mehreren ringförmigen Metallbändern,
Fig. 7 eine Meßanordnung zur Positionserfassung eines Kolbens unter Verwendung von Sensorköpfen gemäß den Fig. 4 und 5,
Fig. 8 den Ansprechbereich eines Annäherungsschalters bei Verwendung eines Sensorkopfes nach Fig. 3,
Fig. 9 den Ansprechbereich eines Annäherungsschalters mit einem Sensorkopf nach den Fig. 4 und 5,
Fig. 10 den Ansprechbereich eines Annäherungsschalters mit einem Sensorkopf nach Fig. 6,
Fig. 11 eine weitere Ausführungsform mit einem etwa C-förmigen amorphen Metallband und
Fig. 12 eine weitere Ausführungsform mit einem etwa U-förmigen amorphen Metallband.

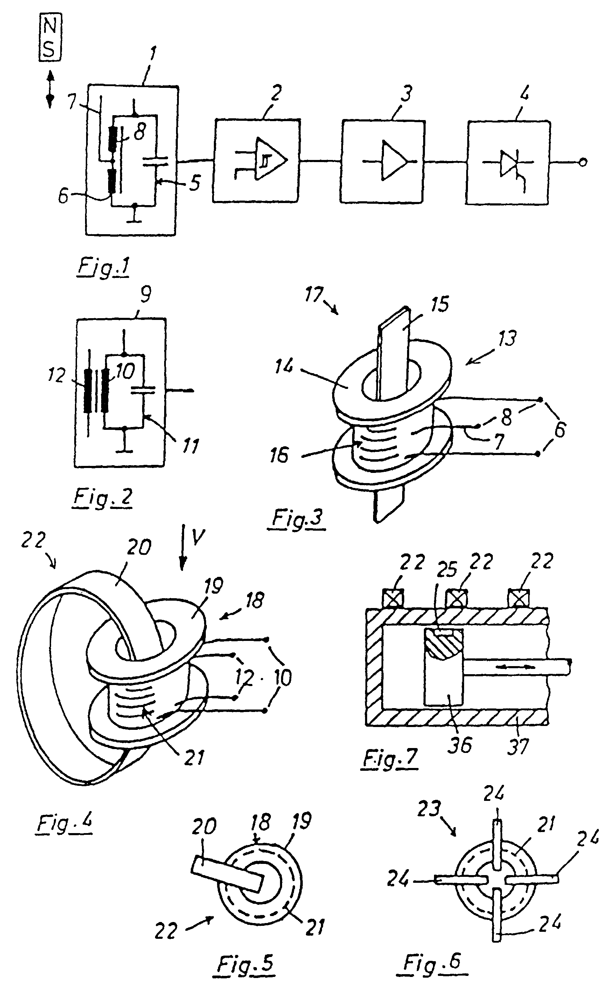

Fig. 1 zeigt in einer Blockbilddarstellung einen elektronischen Annäherungsschalter mit einem Oszillatorteil 1, einer Auswertstufe 2, einem Schaltverstärker 3 und einem Schaltglied 4, wobei letzteres einen Schalttransistor oder vorzugsweise einen Thyristor aufweist. Der Oszillatorteil 1 umfaßt einen HF-Schwingkreis 5 mit einer Schwingkreisspule 6, die eine Anzapfung 7 besitzt. Ein Teil der Schwingkreisspule 6 erhält somit die Funktion einer Kopplungsspule 8, womit der Oszillatorteil 1 z. B. in der sogenannten Hartley-Schaltung betrieben werden kann.

Alternativ ist entsprechend Fig. 2 auch ein Oszillatorteil 9 einsetzbar, bei welchem der Schwingkreisspule 10 eines HF-Schwingkreises 11 eine Kopplungsspule 12 zugeordnet ist, so daß der Oszillatorteil 9, z. B. in der sogenannten Meißner-Schaltung betrieben werden kann.

Fig. 3 zeigt eine Spulenanordnung 13 mit einer Schwingkreisspule 6, welche entsprechend dem Ausführungsbeispiel nach Fig. 1 eine Anzapfung 7 besitzt. Die Schwingkreisspule 6 und der als Kopplungsspule 8 wirkende Windungsteil sitzen auf einem gemeinsamen Wickelkörper 14. Auf der Achse der Spulenanordnung 13 ist ein amorphes Metallband 15 angeordnet, welches als geradliniger, dünner Streifen ausgebildet ist und den Spulenring oder -torus 16 axial durchsetzt. Die Spulenanordnung 13 und das amorphe Metallband 15 bilden zusammen einen Sensorkopf 17 eines Annäherungsschalters mit hoher Ansprechempfindlichkeit.

Fig. 4 zeigt eine Spulenanordnung 18 mit einer Schwingkreisspule 10 und einer Kopplungsspule 12 entsprechend Fig. 2, welche auf einem gemeinsamen Wickelkörper 19 aufgewickelt sind und somit eine enge induktive Kopplung aufweisen. Der Spulenanordnung 18 ist ein amorphes Metallband 20 in Form eines in sich geschlossenen Ringes zugeordnet, welcher die Spulenachse durchsetzt und den Spulentorus 21 umschlingt. Das ringförmige Metallband 20 kann beispielsweise aus einem Streifenstück hergestellt werden, dessen Enden durch Punktschweißung miteinander magnetisch leitend verbunden sind. Die Spulenanordnung 18 und das Metallband 20 bilden zusammen einen Sensorkopf 22. Selbstverständlich kann die Spulenanordnung 13 nach Fig. 3 auch im Zusammenhang mit einem ringförmigen Metallband 20 nach Fig. 4 eingesetzt werden bzw. die Spulenanordnung 18 nach Fig. 4 im Zusammenwirken mit einem geradlinigen Metallband 15 nach Fig. 3.

Fig. 6 zeigt einen Sensorkopf 23 mit einer Spulenanordnung 18 nach den Fig. 4 und 5 und mehreren ringförmigen Metallbändern 24, die längs des Spulentorus 21 verteilt sind.

Bei allen drei Ausführungsbeispielen besitzt das Metallband eine Stärke zwischen 15 und 50 µ, vorzugsweise 30 µ, und eine Breite von ein bis drei Millimetern - bei mehreren Metallbändern 24 auch von einem Millimeter. Bei den Ausführungsbeispielen nach den Fig. 4 bis 6 liegt der Ringdurchmesser in einer Größenordnung von zweibis 10 Millimetern.

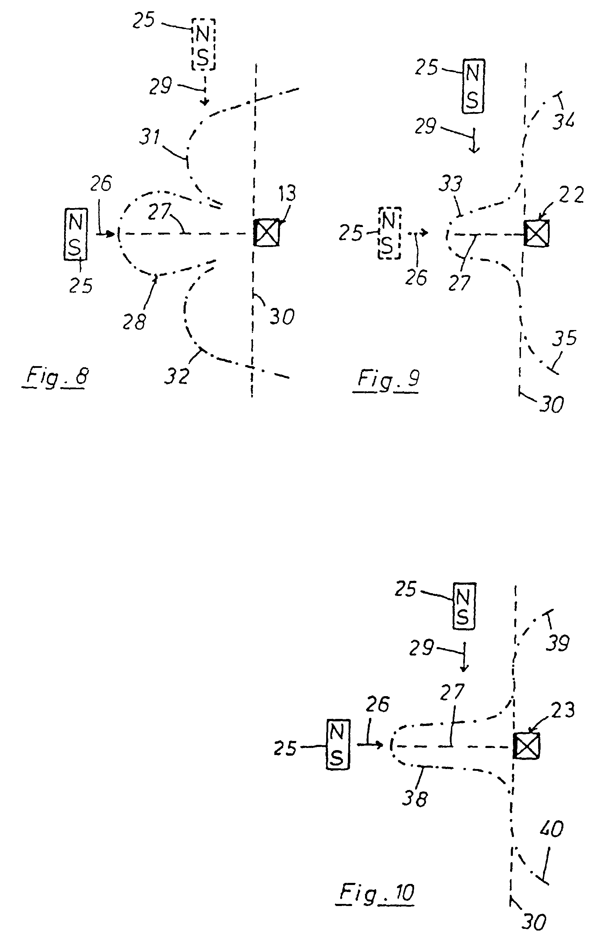

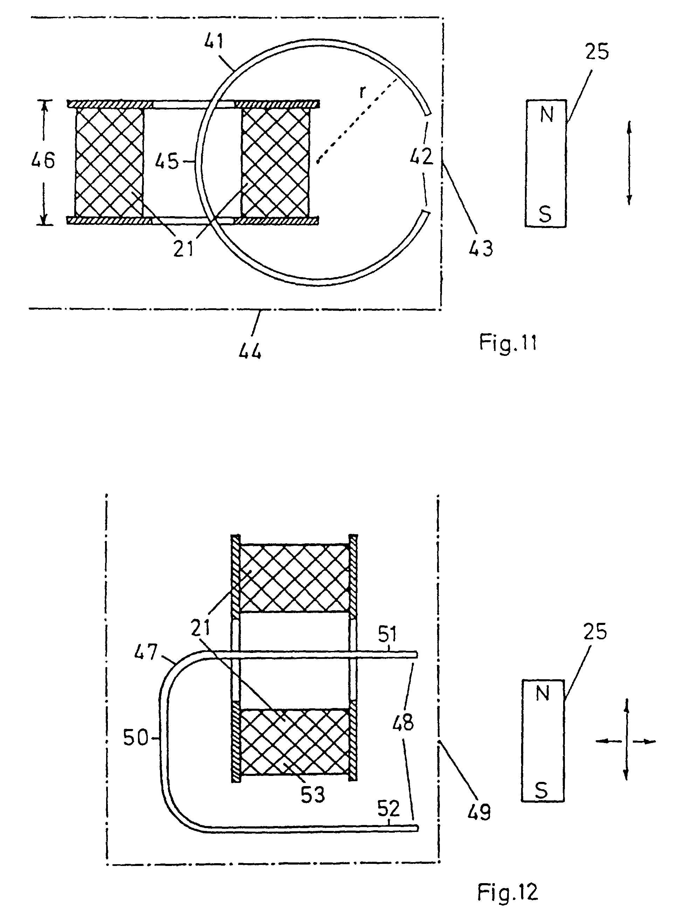

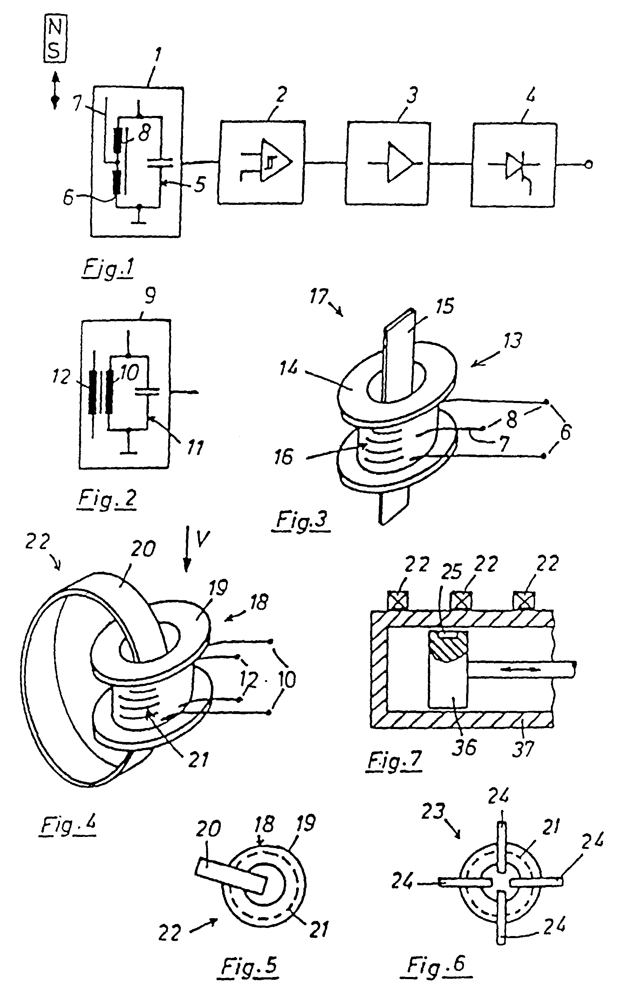

Wie in Fig. 8 in qualitativer Form gezeigt ist, eignet sich ein Näherungsschalter mit einem Sensorkopf 13 mit einem geradlinigen, amorphen Metallband 15 insbesondere für Fälle, in denen ein hoher Schaltabstand erreicht werden soll. Ein permanentmagnetischer Auslöser 25 - oder ein Elektromagnet - wird dabei entsprechend dem Pfeil 26 frontal, d. h. parallel zur Sensorachse 27, an den Sensorkopf 13 herangeführt, wobei es bei Eintreten in eine strichpunktiert dargestellte Ansprechzone 28 zu einem Schaltvorgang kommt.

Bei einer Bewegung des Auslösers 25 quer zur Sensorachse 27 entsprechend dem Pfeil 29 kann es bei einer zu starken Annäherung an die Ebene 30 der aktiven Seite des Sensorkopfes 13 zu Mehrfach-Auslösungen kommen, da neben der zentralen Ansprechzone 28 noch kleinere seitliche Ansprechzonen 31, 32 gegeben sind, die aber noch deutlich vor der Ebene 30 liegen. Die Ansprechzonen 28, 31, 32 sind darüber hinaus hinsichtlich ihrer Quererstreckung relativ breit, so daß eine genaue Ortung des Auslösers 25 bei einer Querbewegung problematisch ist.

Das Problem der Mehrfachauslösung, welches auch von herkömmlichen Annäherungsschaltern, beispielsweise mit Reed-Kontakten, bekannt ist, läßt sich durch einen Annäherungsschalter mit einem Sensorkopf 22 vollständig vermeiden, welcher mit einem ringförmigen Metallband 20 ausgestattet ist. Denn ein solcher Annäherungsschalter weist lediglich unmittelbar vor dem Sensorkopf 22 eine schmale, lanzenförmige Ansprechzone 33 auf, während die nebengeordneten Ansprechzonen 34, 35 fast vollständig hinter der Ebene 30 des Sensorkopfes 22 liegen. Bei einem seitlichen Durchfahren quer zur Sensorachse 27 kommt es auch bei einer sehr dichten Annäherung an die Sensorebene 30 nur zu einem einzigen Aus-Ein-Aus-Schaltvorgang, wobei eine sehr genaue Positionserfassung des Auslösers im Bereich der Ansprechzone 33 möglich ist.

Von daher eignen sich Annäherungsschalter mit Sensorköpfen 22 in besonderer Weise für die Positionserfassung von Kolben 36 (vgl. Fig. 7). Dabei können mehrere Sensorköpfe 22 an der Wand eines metallischen, nichtpermeablen Zylinders 37 angeordnet sein, die die Position des am Kolben 36 befestigten Auslösers 25 erfassen. Da der Abstand zwischen Sensorkopf 22 und Auslöser 25 sehr gering sein kann, können die Sensorköpfe 22 bei Bedarf auch bündig in den Zylinder 37 eingelassen sein.

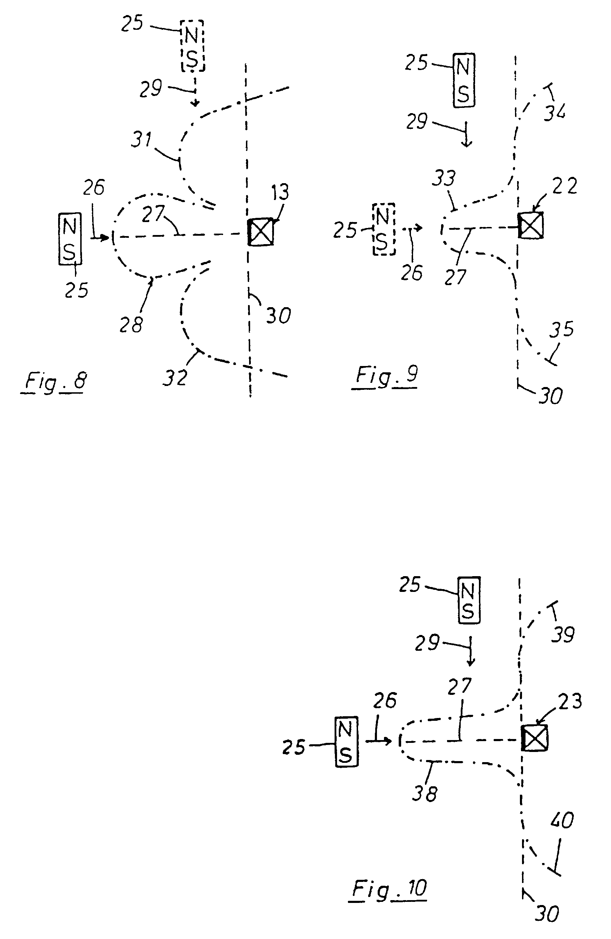

Fig. 10 veranschaulicht schließlich den Anwendungsbereich eines Annäherungsschalters mit einem Sensorkopf 23, welcher mehrere ringförmige Metallbänder 24 aufweist. Durch Verwendung des Sensorkopfes 23 entsteht eine zentrale, lanzenförmige Ansprechzone 38, welche gegenüber dem Ausführungsbeispiels nach Fig. 9 in Richtung der Sensorachse 27 vergrößert ist. Die seitlichen Ansprechzonen 39, 40 liegen dennoch vollständig hinter der Sensorebene 30, womit der Sensorkopf 23 für sämtliche Annäherung s richtungen des Auslösers 25 in gleicher Weise geeignet ist. Bei vielen in der Praxis vorkommenden Anwendungsfällen genügt allerdings auch bei einer Annäherung parallel zur Sensorachse 27 ein kürzerer Ansprechabstand in der Größenordnung von einem Zentimeter oder weniger, so daß hier auch ein Sensorkopf 22 mit nur einem ringförmigen Metallband 20 universal einsetzbar ist.

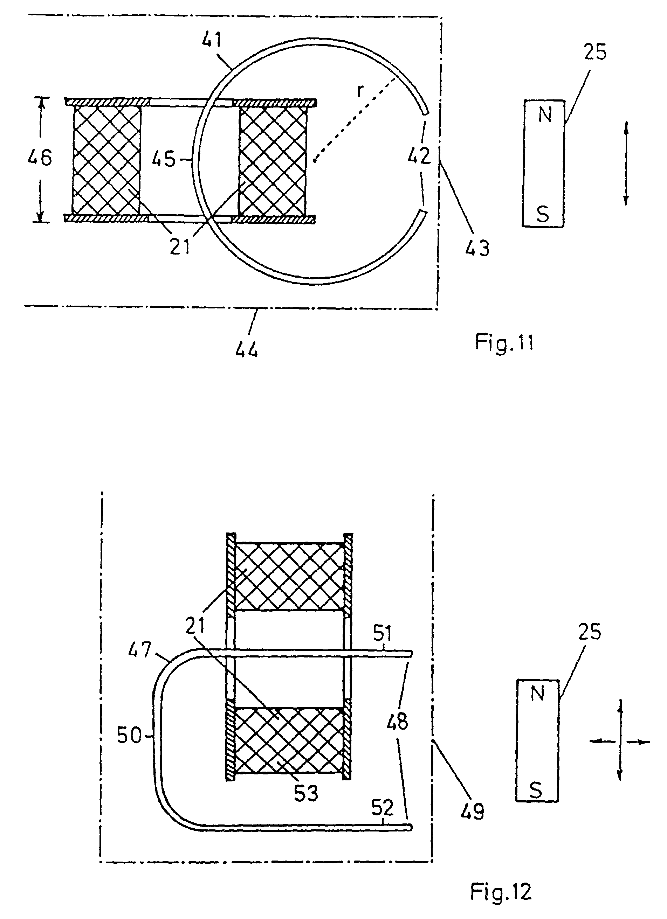

Fig. 11 zeigt eine bevorzugte Ausführungsform, bei welcher das amorphe Metallband als ein C-förmiges Bogenstück 41 ausgebildet ist, das ringförmig gebogen ist und dessen Öffnung 42 an der Ansprechseite 43 des Annäherungsschalters liegt. Die Spule und das Bogenstück 41 können zur Lagestabilisierung in Kunstharz eingegossen sein. Mit der strichpunktierten Linie 44 sind die Außenkonturen des Sensorkopfes des Annäherungsschalters angedeutet. Der Rücken 45 des Bogenstückes 41 liegt im Durchbruch des Spulentorus 21, wobei die Weite der Bogenstücköffnung 42 etwas kleiner als die axiale Abmessung 46 des Spulentorus 21 ist. Der Sensorkopf nach Fig. 11 läßt sich sehr klein bauen. Bei einem Durchmesser r von 3 Millimetern des ringförmigen Bogenstückes 41 beträgt dabei die Weite der Öffnung 42 etwa 2,5 Millimeter.

Bei dem in Fig. 12 gezeigten Ausführungsbeispiel ist das amorphe Metallband als U-förmiges Bogenstück 47 ausgebildet, dessen Öffnung 48 zu der, hier seitlich am Sensorkopf vorgesehenen Ansprechseite 49 hin gerichtet ist. Der Rücken 50 des Bogenstückes 47 liegt an der der Ansprechseite 49 gegenüberliegenden Stirnseite des Spulentorus 21, und das Bogenstück 47 umgreift mit seinen beiden Seitenschenkeln 51, 52 eine Torushälfte 53.

Bei den Ausführungsbeispielen nach den Fig. 11 und 12 ergibt sich in besonders prägnanter Weise die in Fig. 10 veranschaulichte schmale Ansprechzone 38, die bei den Ausführungsbeispielen nach den Fig. 11 und 12 eine Weite von über 30 Millimetern erreichen kann. Die Nebenansprechzonen 39, 40 liegen deutlich hinter der Sensorebene 30, so daß die Probleme einer Mehrfachauslösung sicher vermieden sind.

### Beschreibung für folgende Vertragsstaaten : CH, DE, FR, GB, LI, NL, SE

Die Erfindung betrifft einen magnetfeldabhängigen, elektronischen Annäherungsschalter, welcher durch einen sich annähernden, magnetischen Auslöser betätigt wird, mit einem durch den Auslöser beeinflußbaren HF-Schwingkreis einer Oszillatorschaltung, deren eine Schwingkreisspule und eine Kopplungsspule aufweisender Spulenanordnung ein magnetischer Körper zugeordnet ist, welcher ab einer bestimmten Magnetfeldstärke durch das äußere Magnetfeld des Auslösers unter Entdämpfung des Schwingkreises in magnetische Sättigung treibbar ist.

Durch die DE-AS 11 75 327 ist ein Annäherungsschalter mit einer Oszillatorschaltung bekannt, bei welchen zwischen der Schwingkreisspule und der Rückkopplungsspule eine permeable Metallplatte angeordnet ist. Durch diese Metallplatte wird die Schwingkreisspule weitgehend gegenüber der Kopplungsspule abgeschirmt, so daß nur stark gedämpfte Schwingungen auftreten. Durch Annäherung eines permanentmagnetischen Auslösers kann die dortige Metallplatte in Sättigung getrieben werden, wodurch deren Abschirmwirkung sprungartig reduziert wird und sich somit eine deutliche Entdämpfung des Schwingkreises ergibt. Dieser Effekt wird zur Betätigung eines elektronischen Schalters genutzt. Da der Schwingkreis im Grundzustand stark bedämpft ist, also kein Ausgangssignal liefert, können Fehler in der elektronischen Schaltung, die immer zu einem Abreißen des Signales, nicht aber zu einer Anfachung führen, nicht in irrtümlicher Weise in ein Schaltsignal umgesetzt werden. Der bekannte Annäherungsschalter besitzt allerdings im Verhältnis zu seiner Baugröße eine geringe Ansprechempfindlichkeit, weshalb er bei kleiner Ausbildung - etwa mit nur einem Kubikzentimeter Raumbedarf - nicht durch nicht - permeable Metallwände hindurch, z. B. aus Aluminium oder aus austenitischem Stahl ausgelöst werden kann.

Ferner gilt als Stand der Technik nach Artikel 54 (3) der in der WO-A-86/07637 beschriebene magnetfeldabhängige, elektronische Näherungsschalter, welcher durch einen magnetischen Auslöser betätigt wird, der einen HF-Schwingkreis einer Oszillatorschaltung beeinflußt. Die Spulenanordnung des Schwingkreises enthält eine Schwingkreisspule mit Abgriff für eine Rückkopplungswicklung und einen vom Magnetfeld der Spulen durchsetzten, magnetisierbaren Körper aus einem amorphen Metallband hoher Permeabilität. Bei zunehmender Sättigung des magnetisierbaren Körpers infolge Annäherung des Auslösers wird der Schwingkreis entdämpft, wodurch ein Schaltsignal ausgelöst wird.

Der Erfindung liegt die Aufgabe zugrunde, einen Annäherungsschalter zu schaffen, welcher bei geringer Baugröße eine hohe Ansprechempfindlichkeit aufweist.

Die Aufgabe ist erfindungsgemäß durch einen Annäherungsschalter mit den Merkmalen des Patentanspruches 1 gelöst. Amorphes Metall, welches in der amerikanischen Literatur auch als metallisches Glas bezeichnet wird und welches im deutschen Bereich unter dem geschützten Warenzeichen "Vitrovac" vertrieben wird, ist ein Material, welches eine hohe Permeabilität aufweist, dessen elektrische Leitfähigkeit aber im Vergleich zu Transformator- oder Dynamoblechen gering ist Bei der erfindungsgemäßen Anordnung ist der Schwingkreis im Grundzustand stark bedämpft und wird durch einen sich annähernden magnetischen Auslöser sprunghaft zu starken Schwingungen angeregt, wobei auch bei einer geringen Baugröße eine sehr hohe Ansprechempfindlichkeit gegeben ist. Da die Schwingkreisspule und die Kopplungsspule auf einem gemeinsamen Wickelkörper sitzen, beeinflußt der magnetische Auslöser allerdings nicht bzw. nur unmaßgeblich das Kopplungsverhalten zwischen den beiden Spulen. Entscheidend ist offenbar - trotz der relativ niedrigen elektrischen Leitfähigkeit des amorphen Metallbandes - die Induktion von sehr starken Wirbelströmen im amorphen Metallband. Das Metallband scheint im Grundzustand aufgrund seiner hohen Permeabilität das HF-Schwingkreisfeld so eng an sich zu binden, daß es zu großen Wirbelstromverlusten kommt. Bei Annäherung eines Auslösers wird auch dessen Magnetfeld in besonderer Weise von dem amorphen Metallband angezogen, so daß es schnell in Sättigung getrieben wird. Die in der Praxis beobachtete, starke Entdämpfung des Schwingkreises ist jedoch überraschend, da bei einer Abnahme der Permeabilität des amorphen Metallbandes die Induktivität des Schwingkreises absinken und die Resonanzfrequenz somit ansteigen müßte, wonach eigentlich mit einer Erhöhung der Wirbelstromverluste zu rechnen wäre. In jedem Falle ist in der Praxis ein sehr ausgeprägtes Umschlagen des Dämpfungszustandes festzustellen. Weitere Vorteile bei der Verwendung eines amorphen Metallbandes sind die guten zähelastischen Eigenschaften, die den Annäherungsschalter insbesondere gegenüber Erschütterungen und Stoß unempfindlich machen, sowie die Unabhängigkeit der Kennwerte gegenüber Temperaturschwankungen, die einen Einsatz des Sensorkopfes zwischen -50° C und +150° C ohne einen Temperaturausgleich erlauben.

Weiterhin ist bei der Erfindung jeglicher Ferritkern eingespart, was im Hinblick auf die Massenfertigung solcher Näherungsschalter von erheblicher wirtschaftlicher Bedeutung ist und sehr kleine Bauformen ermöglicht.

Der Erfindung zufolge kam das amorphe Metallband als geradliniger, dünner Streifen ausgebildet sein, welcher auf der Achse der Spulenanordnung angeordnet ist. Mit dieser Ausg estaltung lassen sich sehr hohe Ansprechempfindlichkeiten erzielen, die mit zunehmender Länge des amorphen Metallbandes ansteigen. Schon bei einer Bandlänge von etwa einem Zentime ter lassen sich Ansprechabstände von etwa zehn Zentimetem erreichen.

Nach einer bevorzugten Ausführungsform des Annäherungsschalters, welcher vorzugsweise durch einen sich am Annäherungsschalter entlang bewegenden Auslöser betätigt wird, kann gemäß der Erfindung das amorphe Metallband die Form eines in sich geschlossenen Ringes oder Ovals besitzen, wobei der Ring bzw. das Oval die Spulenachse durchsetzt und den Spulentorus umschlingt. Bei üblichen Annäherungsschaltem, beispielsweise Reed-Kontakten, besteht das Problem, daß es bei einer Bewegung des Auslösers entlang des Annäherungsschalters zu Mehrfach-Auslösungen kommen kann. Durch die Ausbildung des amorphen Metallbandes in Form eines in sich geschlossenen Ringes oder Ovals kommt es dagegen beim Vorbeiführen des Auslösers nur zu einem einzigen Schaltvorgang. Bei einer solchen Querbewegung des Auslösers ist im übrigen die Schaltzone eng begrenzt, so daß eine sehr genaue Positonserfassung des Auslösers gewährleistet ist Durch eine einfache Verformung des ringförmigen Metallbandes lassen sich im übrigen innerhalb gewisser Grenzen die Kenndaten des Annäherungsschalters beeinflussen. Dabei erweist es sich als vorteilhaft, daß das amorphe Metallband durch Biegen oder dgl. Verformungen keine Änderung seiner magnetischen Eigenschaft erfährt.

In weiterer Ausgestaltung der Erfindung können zwei oder mehrere in sich geschlossene, ringförmige oder ovale Metallbänder vorgesehen sein, die längs des Spulentorus verteilt sind. Auch durch die Anordnung von mehreren Metallbandringen lassen sich die Kenndaten eines Annäherungsschalters beeinflussen. Vorteilhaft ist insbesondere eine Vergrößerung des Ansprechbereiches bei einer Bewegung des Auslösers auf den Annäherungsschalter zu, während hinsichtlich einer Querbewegung des Auslösers die Ansprechzone weiterhin sehr schmal bleibt.

Der Erfindung zufolge kann das Metallband eine Stärke zwischen 15 bis 50 µ, vorzugsweise 30 µ, und eine Breite von zwei bis drei Millimetern besitzen. Weiterhin kann gemäß der Erfindung der Ringdurchmesser in der Größenordnung von zwei bis zehn Millimetern liegen. Schon bei diesen geringen Baugrößen lassen sich sehr hohe Ansprechempfindlichkeiten erzielen.

Gemäß einer bevorzugten Ausführungsform der Erfindung ist das amorphe Metallband als ein U- oder C-förmiges Bogenstück ausgebildet, dessen Öffnung an der Ansprechseite des Annäherungsschalters liegt. Bei der bevorzugten Ausführungsform ergibt sich eine sehr schmale, weit ragende, parabelförmige Ansprechzone, wobei insbesondere Nebenansprechzonen vermieden sind. Ein solcher Annäherungsschalter ist für die unterschiedlichsten Empfindlichkeitsbereiche einsetzbar und erübrigt die Bereithaltung verschiedener Typen. Der Rücken des Bogenstückes liegt dabei vorteilhafterweise im Spulentorus, wodurch sich eine exakt symmetrische Ansprechzone ergibt.

Nach weiteren Merkmalen der Erfindung kann die Weite der Bogenstücköffnung etwa gleich oder kleiner als die axiale Abmessung des Spulentorus sein. Eine fertigungstechnisch besonders günstige Ausführungsform ergibt sich bei einer ringförmigen Ausbildung des Bogenstückes und bei einer Ringöffnungsweite, die etwa gleich oder kleiner als der Radius des Bogenstückes ist. Bei einem Radius von etwa 3 Millimetern des ringförmigen Bogenstückes beträgt die Öffnungsweite etwa 2,5 Millimeter.

Gemäß einer alternativen Ausführungsform kann der Erfindung zufolge vorgesehen werden, daß der Rücken des Bogenstückes an der der Ansprechseite gegenüberliegenden Stirnseite des Spulentorus liegt und daß das Bogenstück mit seinen Seitenschenkeln eine Torusfhälfte umgreift.

Die Erfindung wird im folgenden anhand der Zeichnung näher erläutert. Es zeigen:
Fig. 1 ein Prinzipschaltbild eines Annäherungsschalters gemäß einer ersten Ausführungsform,
Fig. 2 eine altemative Ausführungsform eines Oszillatorteils des Annäherungschalters in einer Blockbilddarstellung,
Fig. 3 die Spulenanordnung des Oszillatorteils nach Fig. 2 mit einem geradlinigen, amorphen Metallband in perspektivischer Darstellung,
Fig. 4 die Spulenanordnung des Oszillatorteils nach Fig. 1 mit einem ringförmigen, amorphen Metallband in perspektivischer Darstellung,
Fig. 5 den aus Spulenanordnung und ringförmigem Metallband bestehenden Sensorkopf gemäß einer Blickrichtung V in Fig. 4,
Fig. 6 eine alternative Ausführungsform eines Sensorkopfes mit mehreren ringförmigen Metallbändern,
Fig. 7 eine Meßanordnung zur Positionserfassung eines Kolbens unter Verwendung von Sensorköpfen gemäß den Fig. 4 und 5,
Fig. 8 den Ansprechbereich eines Annäherungsschalters bei Verwendung eines Sensorkopfes nach Fig. 3,
Fig. 9 den Ansprechbereich eines Annäherungsschalters mit einem Sensorkopf nach den Fig. 4 und 5,
Fig. 10 den Ansprechbereich eines Annäherungsschalters mit einem Sensorkopf nach Fig. 6,
Fig. 11 eine weitere Ausführungsform mit einem etwa C-förmigen amorphen Metallband und
Fig. 12 eine weitere Ausführungsform mit einem etwa U-förmigen amorphen Metallband.

Fig. 1 zeigt in einer Blockbilddarstellung einen elektronischen Annäherungsschalter mit einem Oszillatorteil 1, einer Auswertstufe 2, einem Schaltverstärker 3 und einem Schaltglied 4, wobei letzteres einen Schalttransistor oder vorzugsweise einen Thyristor aufweist. Der Oszillatorteil 1 umfaßt einen HF-Schwingkreis 5 mit einer Schwingkreisspule 6, die eine Anzapfung 7 besitzt. Ein Teil der Schwingkreisspule 6 erhält somit die Funktion einer Kopplungsspule 8, womit der Oszillatorteil 1 z. B. in der sogenannten Hartley-Schaltung betrieben werden kann.

Alternativ ist entsprechend Fig. 2 auch ein Oszillatorteil 9 einsetzbar, bei welchem der Schwingkreisspule 10 eines HF-Schwingkreises 11 eine Kopplungsspule 12 zugeordnet ist, so daß der Oszillatorteil 9, z. B. in der sogenannten Meißner-Schaltung betrieben werden kann.

Fig. 3 zeigt eine Spulenanordnung 13 mit einer Schwingkreisspule 6, welche entsprechend dem Ausführungsbeispiel nach Fig. 1 eine Anzapfung 7 besitzt. Die Schwingkreisspule 6 und der als Kopplungsspule 8 wirkende Windungsteil sitzen auf einem gemeinsamen Wickelkörper 14. Auf der Achse der Spulenanordnung 13 ist ein amorphes Metallband 15 angeordnet, welches als geradliniger, dünner Streifen ausgebildet ist und den Spulenring oder -torus 16 axial durchsetzt. Die Spulenanordnung 13 und das amorphe Metallband 15 bilden zusammen einen Sensorkopf 17 eines Annäherungsschalters mit hoher Ansprechempfindlichkeit.

Fig. 4 zeigt eine Spulenanordnung 18 mit einer Schwingkreisspule 10 und einer Kopplungsspule 12 entsprechend Fig. 2, welche auf einem gemeinsamen Wickelkörper 19 aufgewickelt sind und somit eine enge induktive Kopplung aufweisen. Der Spulenanordnung 18 ist ein amorphes Metallband 20 in Form eines in sich geschlossenen Ringes zugeordnet, welcher die Spulenachse durchsetzt und den Spulentorus 21 umschlingt. Das ringförmige Metallband 20 kann beispielsweise aus einem Streifenstück hergestellt werden, dessen Enden durch Punktschweißung miteinander magnetisch leitend verbunden sind. Die Spulenanordnung 18 und das Metallband 20 bilden zusammen einen Sensorkopf 22. Selbstverständlich kann die Spulenanordnung 13 nach Fig. 3 auch im Zusammenhang mit einem ringförmigen Metallband 20 nach Fig. 4 eingesetzt werden bzw. die Spulenanordnung 18 nach Fig. 4 im Zusammenwirken mit einem geradlinigen Metallband 15 nach Fig. 3.

Fig. 6 zeigt einen Sensorkopf 23 mit einer Spulenanordnung 18 nach den Fig. 4 und 5 und mehreren ringförmigen Metallbändern 24, die längs des Spulentorus 21 verteilt sind.

Bei allen drei Ausführungsbeispielen besitzt das Metallband eine Stärke zwischen 15 und 50 µ, vorzugsweise 30 µ, und eine Breite von ein bis drei Millimetern - bei mehreren Metallbändern 24 auch von einem Millimeter. Bei den Ausführungsbeispielen nach den Fig. 4 bis 6 liegt der Ringdurchmesser in einer Größenordnung von zweibis 10 Millimetern.

Wie in Fig. 8 in qualitativer Form gezeigt ist, eignet sich ein Näherungsschalter mit einem Sensorkopf 13 mit einem geradlinigen, amorphen Metallband 15 insbesondere für Fälle, in denen ein hoher Schaltabstand erreicht werden soll. Ein permanentmagnetischer Auslöser 25 - oder ein Elektromagnet - wird dabei entsprechend dem Pfeil 26 frontal, d. h. parallel zur Sensorachse 27, an den Sensorkopf 13 herangeführt, wobei es bei Eintreten in eine strichpunktiert dargestellte Ansprechzone 28 zu einem Schaltvorgang kommt.

Bei einer Bewegung des Auslösers 25 quer zur Sensorachse 27 entsprechend dem Pfeil 29 kann es bei einer zu starken Annäherung an die Ebene 30 der aktiven Seite des Sensorkopfes 13 zu Mehrfach-Auslösungen kommen, da neben der zentralen Ansprechzone 28 noch kleinere seitliche Ansprechzonen 31, 32 gegeben sind, die aber noch deutlich vor der Ebene 30 liegen. Die Ansprechzonen 28, 31, 32 sind darüber hinaus hinsichtlich ihrer Quererstreckung relativ breit, so daß eine genaue Ortung des Auslösers 25 bei einer Querbewegung problematisch ist.

Das Problem der Mehrfachauslösung, welches auch von herkömmlichen Annäherungsschaltern, beispielsweise mit Reed-Kontakten, bekannt ist, läßt sich durch einen Annäherungsschalter mit einem Sensorkopf 22 vollständig vermeiden, welcher mit einem ringförmigen Metallband 20 ausgestattet ist. Denn ein solcher Annäherungsschalter weist lediglich unmittelbar vor dem Sensorkopf 22 eine schmale, lanzenförmige Ansprechzone 33 auf, während die nebengeordneten Ansprechzonen 34, 35 fast vollständig hinter der Ebene 30 des Sensorkopfes 22 liegen. Bei einem seitlichen Durchfahren quer zur Sensorachse 27 kommt es auch bei einer sehr dichten Annäherung an die Sensorebene 30 nur zu einem einzigen Aus-Ein-Aus-Schaltvorgang, wobei eine sehr genaue Positionserfassung des Auslösers im Bereich der Ansprechzone 33 möglich ist.

Von daher eignen sich Annäherungsschalter mit Sensorköpfen 22 in besonderer Weise für die Positionserfassung von Kolben 36 (vgl. Fig. 7). Dabei können mehrere Sensorköpfe 22 an der Wand eines metallischen, nichtpermeablen Zylinders 37 angeordnet sein, die die Position des am Kolben 36 befestigten Auslösers 25 erfassen. Da der Abstand zwischen Sensorkopf 22 und Auslöser 25 sehr gering sein kann, können die Sensorköpfe 22 bei Bedarf auch bündig in den Zylinder 37 eingelassen sein.

Fig. 10 veranschaulicht schließlich den Anwendungsbereich eines Annäherungsschalters mit einem Sensorkopf 23, welcher mehrere ringförmige Metallbänder 24 aufweist. Durch Verwendung des Sensorkopfes 23 entsteht eine zentrale, lanzenförmige Ansprechzone 38, welche gegenüber dem Ausführungsbeispiels nach Fig. 9 in Richtung der Sensorachse 27 vergrößert ist. Die seitlichen Ansprechzonen 39, 40 liegen dennoch vollständig hinter der Sensorebene 30, womit der Sensorkopf 23 für sämtliche Annäherung s richtungen des Auslösers 25 in gleicher Weise geeignet ist. Bei vielen in der Praxis vorkommenden Anwendungsfällen genügt allerdings auch bei einer Annäherung parallel zur Sensorachse 27 ein kürzerer Ansprechabstand in der Größenordnung von einem Zentimeter oder weniger, so daß hier auch ein Sensorkopf 22 mit nur einem ringförmigen Metallband 20 universal einsetzbar ist.

Fig. 11 zeigt eine bevorzugte Ausführungsform, bei welcher das amorphe Metallband als ein C-förmiges Bogenstück 41 ausgebildet ist, das ringförmig gebogen ist und dessen Öffnung 42 an der Ansprechseite 43 des Annäherungsschalters liegt. Die Spule und das Bogenstück 41 können zur Lagestabilisierung in Kunstharz eingegossen sein. Mit der strichpunktierten Linie 44 sind die Außenkonturen des Sensorkopfes des Annäherungsschalters angedeutet. Der Rücken 45 des Bogenstückes 41 liegt im Durchbruch des Spulentorus 21, wobei die Weite der Bogenstücköffnung 42 etwas kleiner als die axiale Abmessung 46 des Spulentorus 21 ist. Der Sensorkopf nach Fig. 11 läßt sich sehr klein bauen. Bei einem Durchmesser r von 3 Millimetern des ringförmigen Bogenstückes 41 beträgt dabei die Weite der Öffnung 42 etwa 2,5 Millimeter.

Bei dem in Fig. 12 gezeigten Ausführungsbeispiel ist das amorphe Metallband als U-förmiges Bogenstück 47 ausgebildet, dessen Öffnung 48 zu der, hier seitlich am Sensorkopf vorgesehenen Ansprechseite 49 hin gerichtet ist. Der Rücken 50 des Bogenstückes 47 liegt an der der Ansprechseite 49 gegenüberliegenden Stirnseite des Spulentorus 21, und das Bogenstück 47 umgreift mit seinen beiden Seitenschenkeln 51, 52 eine Torushälfte 53.

Bei den Ausführungsbeispielen nach den Fig. 11 und 12 ergibt sich in besonders prägnanter Weise die in Fig. 10 veranschaulichte schmale Ansprechzone 38, die bei den Ausführungsbeispielen nach den Fig. 11 und 12 eine Weite von über 30 Millimetern erreichen kann. Die Nebenansprechzonen 39, 40 liegen deutlich hinter der Sensorebene 30, so daß die Probleme einer Mehrfachauslösung sicher vermieden sind.

## Patentansprüche (Patentansprüche für folgende(n) Vertragsstaat(en): AT, BE, IT)

1. Magnetfeldabhängiger, elektronischer Annäherungsschalter, welcher durch einen sich annähernden, magnetischen Auslöser (25) betätigt wird, mit einem durch den Auslöser (25) beeinflußbaren HF-Schwingkreis (5, 11) einer Oszillatorschaltung (1, 9), deren Spulenanordnung (13, 18) eine Schwingkreisspule (6, 10), eine Kopplungsspule (8, 12) und einen vom Magnetfeld der Spulen durchsetzten magnetisierbaren Körper aufweist, welcher ab einer bestimmten Magnetfeldstärke durch das äußere Magnetfeld des Auslösers (25) unter Entdämpfung des Schwingkreises (5, 11) in magnetische Sättigung treibbar ist, dadurch gekennzeichnet, daß der magnetisierbare Körper aus einem amorphen oder überwiegend amorphen Metallband (15, 20) hoher Permeabilität, dessen den Schwingungszustand der Oszillatorschaltung bestimmende Verluste mit zunehmender magnetischer Sättigung abnehmen, besteht, und daß die Schwingkreisspule (6,10) und die Kopplungsspule (8, 12) auf einem gemeinsamen Wickelkörper (14, 19) sitzen.

2. Schalter nach Anspruch 1, dadurch gekennzeichnet, daß das amorphe Metallband (15) als geradliniger, dünner Streifen ausgebildet ist, welcher auf der Achse der Spulenanordnung (13) angeordnet ist und den Spulentorus (16) durchsetzt.

3. Schalter nach Anspruch 1, welcher vorzugsweise durch einen sich am Annäherungsschalter entlang bewegenden Auslöser (25) betätigt wird, dadurch gekennzeichnet, daß das amorphe Metallband (20) die Form eines in sich geschlossenen Ringes oder Ovals besitzt, wobei der Ring bzw. das Oval die Spulenachse durchsetzt und den Spulentorus (21) umschlingt.

4. Schalter nach Anspruch 3, dadurch gekennzeichnet, daß zwei oder mehrere in sich geschlossene, ringförmige bzw. ovale Metallbänder (24) vorgesehen sind, die längs des Spulentorus (21) verteilt sind.

5. Schalter nach einem oder mehreren der vorgangengangen Ansprüche, dadurch gekennzeichnet, daß das Metallband (15, 20, 24) eine Stärke zwischen 15 und 50 µ, vorzugsweise 30 µ, und eine Breite von ein bis drei Millimetern besitzt.

6. Schalter nach einem oder mehreren der Ansprüche 3 bis 5, dadurch gekennzeichnet, daß der Ringdurchmesser in der Größenordnung von zwei bis zehn Millimetern liegt.

7. Schalter nach Anspruch 1, dadurch gekennzeichnet, daß das amorphe Metallband als U- oder C-förmiges Bogenstück (41, 47) ausgebildet ist, dessen Öffnung (42, 48) an der Ansprechseite (43, 49) des Annäherungsschalters liegt.

8. Schalter nach Anspruch 7, dadurch gekennzeichnet, daß der Rücken (45) des Bogenstückes (41) im Spulentorus (21) liegt.

9. Schalter nach den Ansprüchen 7 oder 8, dadurch gekennzeichnet, daß die Weite der Bogenstücköffnung (42) etwa gleich oder kleiner als die axiale Abmessung (46) des Spulentorus (21) ist.

10. Schalter nach Anspruch 9, dadurch gekennzeichnet, daß das Bogenstück (41) ringförmig gebogen ist und die Weite der Öffnung (42) etwa gleich oder kleiner als der Radius (r) des Bogenstückes (41) ist.

11. Schalter nach Anspruch 10, dadurch gekennzeichnet, daß der Radius (r) etwa drei Millimeter und die Weite der Öffnung (42) etwa 2, 5 Millimeter betragen.

12. Schalter nach Anspruch 7, dadurch gekennzeichnet, daß der Rücken (50) des Bogenstückes (47) an der der Ansprechseite (49) gegenüberliegenden Stimseite des Spulentorus (21) liegt und daß das Bogenstück (47) mit seinen Seitenschenkeln (51, 52) eine Torushälfte (53) umgreift.

## Patentansprüche (Patentansprüche für folgende(n) Vertragsstaat(en): CH, DE, FR, GB, LI, NL, SE)

1. Magnetfeldabhängiger, elektronischer Annäherungsschalter, welcher durch einen sich annähernden, magnetischen Auslöser (25) betätigt wird, mit einem durch den Auslöser (25) beeinflußbaren HF-Schwingkreis (5, 11) einer Oszillatorschaltung (1, 9), deren Spulenanordnung (13, 18) eine Schwingkreisspule (6, 10), eine Kopplungsspule (8, 12) und einen vom Magnetfeld der Spulen durchsetzten magnetisierbaren Körper aufweist, welcher ab einer bestimmten Magnetfeldstärke durch das äußere Magnetfeld des Auslösers (25) unter Entdämpfung des Schwingkreises (5, 11) in magnetische Sättigung treibbar ist, wobei der magnetisierbare Körper ein amorphes oder überwiegend amorphes Metall hoher Permeabilität umfaßt, dessen den Schwingungszustand der Oszillatorschaltung bestimmende Verluste mit zunehmender magnetischer Sättigung abnehmen, wobei die Schwingkreisspule (6, 10) und die Kopplungsspule (8, 12) auf einem gemeinsamen Wickelkörper (14, 19) sitzen und wobei der magnetisierbare Körper aus einem Metallband (15, 20) besteht und als Streifen ausgebildet ist, welcher den Spulentorus (16) durchsetzt.

2. Schalter nach Anspruch 1, dadurch gekennzeichnet, daß der Streifen (15) dünn und geradlinig ist und auf der Achse der Spulenanordnung (13) angeordnet ist.

3. Schalter nach Anspruch 1, welcher vorzugsweise durch einen sich am Annäherungsschalter entlang bewegenden Auslöser (25) betätigt wird, dadurch gekennzeichnet, daß das amorphe Metallband (20) die Form eines in sich geschlossenen Ringes oder Ovals besitzt, wobei der Ring bzw. das Oval die Spulenachse durchsetzt und den Spulentorus (21) umschlingt.

4. Schalter nach Anspruch 3, dadurch gekennzeichnet, daß zwei oder mehrere in sich geschlossene, ringförmige bzw. ovale Metallbänder (24) vorgesehen sind, die längs des Spulentorus (21) verteilt sind.

5. Schalter nach einem oder mehreren der vorgangengangen Ansprüche, dadurch gekennzeichnet, daß das Metallband (15, 20, 24) eine Stärke zwischen 15 und 50 µ, vorzugsweise 30 µ, und eine Breite von ein bis drei Millimetern besitzt.

6. Schalter nach einem oder mehreren der Ansprüche 3 bis 5, dadurch gekennzeichnet, daß der Ringdurchmesser in der Größenordnung von zwei bis zehn Millimetern liegt.

7. Schalter nach Anspruch 1, dadurch gekennzeichnet, daß das amorphe Metallband als U- oder C-förmiges Bogenstück (41, 47) ausgebildet ist, dessen Öffnung (42, 48) an der Ansprechseite (43, 49) des Annäherungsschalters liegt.

8. Schalter nach Anspruch 7, dadurch gekennzeichnet, daß der Rücken (45) des Bogenstückes (41) im Spulentorus (21) liegt.

9. Schalter nach den Ansprüchen 7 oder 8, dadurch gekennzeichnet, daß die Weite der Bogenstücköffnung (42) etwa gleich oder kleiner als die axiale Abmessung (46) des Spulentorus (21) ist.

10. Schalter nach Anspruch 9, dadurch gekennzeichnet, daß das Bogenstück (41) ringförmig gebogen ist und die Weite der Öffnung (42) etwa gleich oder kleiner als der Radius (r) des Bogenstückes (41) ist.

11. Schalter nach Anspruch 10, dadurch gekennzeichnet, daß der Radius (r) etwa drei Millimeter und die Weite der Öffnung (42) etwa 2, 5 Millimeter betragen.

12. Schalter nach Anspruch 7, dadurch gekennzeichnet, daß der Rücken (50) des Bogenstückes (47) an der der Ansprechseite (49) gegenüberliegenden Stirnseite des Spulentorus (21) liegt und daß das Bogenstück (47) mit seinen Seitenschenkeln (51, 52) eine Torushälfte (53) umgreift.

## Claims (Claims for the following Contracting State(s): AT, BE, IT)

1. Magnetic-field-dependent, electronic proximity switch, operated by an approaching magnetic trigger (25), with a HF resonant circuit (5, 11) of an oscillatory circuit (1, 9) whose coil arrangement (13, 18) has a resonant circuit coil (6, 10), a coupling coil (8, 12) and a magnetisable body, intersected by the magnetic field of the coils, which at a determined magnetic field strength can be brought to magnetic saturation by the external magnetic field of the trigger (25) when the damping of the resonant circuit (5, 11) is reduced, characterised in that the magnetisable body consists of a strip of amorphous or mainly amorphous metal (15, 20) of high permeability, whose losses, which determine the oscillatory regime of the oscillator switch, decrease as magnetic saturation increases, and in that the resonant circuit coil (6, 10) and the coupling coil (8, 12) are positioned on a common former (14, 19).

2. Switch according to Claim 1, characterised in that the strip of amorphous metal (15) is shaped as a straight thin strip, which is positioned on the axis of the coils (13) and intersects the coil torus (16).

3. Switch according to Claim 1, ideally operated by a trigger (25) moving along the proximity switch, characterised in that the strip of amorphous metal (20) takes the form of a ring or oval closed on itself, the ring or oval intersecting the coil axis and surrounding the coil torus (21).

4. Switch according to Claim 3, characterised in that two or more closed ring-shaped or oval metal strips (24) are provided, which are distributed along the coil torus (21).

5. Switch according to one or more of the previous Claims, characterised in that the metal strip (15, 20, 24) has a strength of between 15 and 50 m, preferably 30 m, and a breadth of one to three millimetres.

6. Switch according to one or more of Claims 3 to 5 characterised in that the ring diameter is between 2 and 10 millimetres.

7. Switch according to Claim 1, characterised in that the strip of amorphous metal is a U- or C-shaped curved piece (41, 47), whose opening (42, 48), lies on the operating side (43, 49) of the proximity switch.

8. Switch according to Claim 7, characterised in that the reverse side (45) of the curved piece (41) lies in the coil torus (21).

9. Switch according to Claim 7 or 8, characterised in that the width of the opening (42) of the curved piece is roughly equal to, or smaller than, the axial dimension (46) of the coil torus (21).

10. Switch according to Claim 9, characterised in that the curved piece (41) is bent into the shape of a ring and the width of the opening (42) is roughly equal to, or smaller than, the radius (r) of the curved piece (41).

11. Switch according to Claim 10, characterised in that the radius (r) is roughly 3 millimetres and the width of the opening (42) roughly 2.5 millimetres.

12. Switch according to Claim 7, characterised in that the reverse side (50) of the curved piece (47) lies on the face of the coil torus (21) lying opposite to the operating side (49) and that the curved piece (47) grips one half of the torus (53) with its side shafts (51, 52).

## Claims (Claims for the following Contracting State(s): CH, DE, FR, GB, LI, NL, SE)

1. Magnetic-field-dependent electronic proximity switch, operated by an approaching magnetic trigger (25), with a HF-oscillator (5,11) which can be influenced by the trigger (25), an oscillatory circuit (1,9), whose coil arrangement (13,18) displays an oscillator coil (6,10), a coupling coil (8,12) and a magnetisable element, transected by the magnetic field of the coils, which when a given magnetic field strength is reached may be placed in magnetic saturation by the external magnetic field of the trigger (25), the attenuation of the oscillator (5,11) being equalised, wherein the magnetisable element comprises an amorphous or essentially amorphous metal of high permeability, whose losses, which determine the oscillatory state of the oscillatory circuit, decrease with increasing magnetic saturation, wherein the oscillator coil (6,10) and the coupling coil (8,12) rest on a common winding element (14,19) and wherein the magnetisable element consists of a band of metal (15,20) and is designed as a strip transecting the coil torus (16).

2. Switch as claimed in Claim 1, characterised in that the strip (15) is thin and straight and is located on the axis of the coil arrangement (13).

3. Switch according to Claim 1, ideally operated by a trigger (25) moving along the proximity switch, characterised in that the strip of amorphous metal (20) takes the form of a ring or oval closed on itself, the ring or oval intersecting the coil axis and surrounding the coil torus (21).

4. Switch according to Claim 3, characterised in that two or more closed ring-shaped or oval metal strips (24) are provided, which are distributed along the coil torus (21).

5. Switch according to one or more of the previous Claims, characterised in that the metal strip (15, 20, 24) has a strength of between 15 and 50 m, preferably 30 m, and a breadth of one to three millimetres.

6. Switch according to one or more of Claims 3 to 5 characterised in that the ring diameter is between 2 and 10 millimetres.

7. Switch according to Claim 1, characterised in that the strip of amorphous metal is a U- or C-shaped curved piece (41, 47), whose opening (42, 48), lies on the operating side (43, 49) of the proximity switch.

8. Switch according to Claim 7, characterised in that the reverse side (45) of the curved piece (41) lies in the coil torus (21).

9. Switch according to Claim 7 or 8, characterised in that the width of the opening (42) of the curved piece is roughly equal to, or smaller than, the axial dimension (46) of the coil torus (21).

10. Switch according to Claim 9, characterised in that the curved piece (41) is bent into the shape of a ring and the width of the opening (42) is roughly equal to, or smaller than, the radius (r) of the curved piece (41).

11. Switch according to Claim 10, characterised in that the radius (r) is roughly 3 millimetres and the width of the opening (42) roughly 2.5 millimetres.

12. Switch according to Claim 7, characterised in that the reverse side (50) of the curved piece (47) lies on the face of the coil torus (21) lying opposite to the operating side (49) and that the curved piece (47) grips one half of the torus (53) with its side shafts (51, 52).

## Revendications (Revendications pour l'(les) Etat(s) contractant(s) suivant(s): AT, BE, IT)

1. Commutateur de proximité électronique, sensible au champ magnétique, qui est actionné par un déclencheur (25) magnétique en se rapprochant, à circuit oscillant-HF (5, 11), influençable par le déclencheur (25), d'un montage oscillateur (1, 9) dont l'ensemble de bobines (13, 18) comprend une bobine de circuit oscillant (6, 10), une bobine de couplage (8, 12) et un corps magnétisable traversé par le champ magnétique des bobines et qui, à partir d'une intensité de champ magnétique déterminée, est amené à saturation magnétique par le champ magnétique exteme du déclencheur (25) avec diminution de l'amortissement du circuit oscillant (5, 11), caractérisé par le fait que le corps magnétisable est constitué d'une bande métallique (15, 20) amorphe ou essentiellement amorphe, de haute perméabilité, dont les pertes, déterminant l'état d'oscilltion du circuit oscillateur, diminuent avec une saturation magnétique croissante et la bobine de circuit oscillalant (6, 10) et la bobine de couplage (8,12) sont montées sur un corps d'enroulement commun (14, 19).

2. Commutateur selon la revendication 1, caractérisé par le fait que la bande métallique (15) amorphe est en forme de lame mince rectiligne qui est située sur l'axe de l'agencement de bobines (13) et traverse le tore de bobines (16).

3. Commutateur selon la revendication 1, qui est avantageusement actionné par un déclencheur (25) déplaçant le long du commutateur de proximité, caractérisé par le fait que la bande métallique amorphe (20) possède la forme d'un anneau ou ovale fermé sur lui-même, l'anneau ou ovale traversant l'axe de bobines et embrassant le tore de bobines (21).

4. Commutateur selon la revendication 3, caractérisé par le fait que sont prévues deux ou plus de deux bandes métalliques (24) annulaires ou ovales fermées sur elles-mêmes, que sont réparties le long du tore de bobines (21).

5. Commutateur selon l'une des revendications précédentes, caractérisé par le fait que la bande métallique (15, 20, 24) possède une épaisseur commprise entre 15 et 50 µ, de Préférence 30 µ, et une largeur de un à trois milliètres.

6. Commutateur selon l'une des revendications 3 à 5, caractérisé par le fait que le diamètre d'anneau est de l'ordre de grandeur de deux à dix millimètres.

7. Commutateur selon la revendication 1 caractérisé par le fait que la bande métallique amorphe est en forme de pièce cintrée en U ou C (41, 47) dont l' ouverture (42, 48) est située du côté réponse (43, 49) du commutateur de proximité.

8. Commutateur selon la revendication 7, caractérisé par le fait que le dos (45) de la pièce cintrée (41) est situé dans le tore de bobines (21).

9. Commutateur selon la revendication 7 ou 8, caractérisé par le fait que la largeur d'ouverture (42) de la pièce centrée est à peu près égale ou inférieure à la dimension axiale (46) du tore de bobines (21).

10. Commutateur selon la revendication 9, caractérisé par le fait que la pièce cintrée (41) est cintrée en forme d'anneau et la largeur (42) de l'ouverture est à peu près égale ou inférieure au rayon (r) de la pièce cintrée (41) .

11. Commutateur selon la revendication 10, caractérisé par le fait que le rayon (r) est d'environ trois millimètres et la largeur de l'ouverture (42) d'environ 2,5 millimètres.

12. Commutateur selon la revendication 7, caractérisé par le fait que le dos (50) de la pièce cintrée (47) est située du côté frontal du tore de bobines (21) opposé au côté réponse (49) et la pièce centrée (47) enserre par ses branches latérales (51, 52) une moitié de tore (53).

## Revendications (Revendications pour l'(les) Etat(s) contractant(s) suivant(s): CH, DE, FR, GB, LI, NL, SE)

1. Interrupteur électronique de proximité dépendant d'un champ magnétique, actionné par un déclencheur magnétique (25) qui s'approche, comportant un circuit oscillant HF (5, 11), influençable par le déclencheur (25), d'un montage oscillateur (1, 9) dont le système de bobines (13, 18) présente une bobine de circuit oscillant (6, 10), une bobine de couplage (8, 12) et un corps aimantable traversé par le champ magnétique des bobines et pouvant, à partir d'une intensité de champ magnétique déterminée, être poussé à saturation magnétique par le champ magnétique extérieur du déclencheur (25) avec compensation de l'amortissement du circuit oscillant (5, 11), ce corps aimantable comprenant un métal amorphe ou principalement amorphe à haute perméabilité dont les pertes, déterminant l'état d'oscillation du montage oscillateur, diminuent lorsque la saturation magnétique augmente, la bobine de circuit oscillant (6, 10) et la bobine de couplage (8, 12) étant montées sur une carcasse commune (14, 19) et le corps aimantable étant constitué d'une bande métallique (15, 20) et se présentant sous la forme d'une bande qui traverse le tore de bobines (16).

2. Interrupteur selon la revendication 1, caractérisé par le fait que la bande (15) est mince et droite et placée sur l'axe du système de bobines (13).

3. Commutateur selon la revendication 1, qui est avantageusement actionné par un déclencheur (25) déplaçant le long du commutateur de proximité, caractérisé par le fait que la bande métallique amorphe (20) possède la forme d'un anneau ou ovale fermé sur lui-même, l'anneau ou ovale traversant l'axe de bobines et embrassant le tore de bobines (21).

4. Commutateur selon la revendication 3, caractérisé par le fait que sont prévues deux ou plus de deux bandes métalliques (24) annulaires ou ovales fermées sur elles-mêmes, que sont réparties le long du tore de bobines (21).

5. Commutateur selon l'une des revendications précédentes, caractérisé par le fait que la bande métallique (15, 20, 24) possède une épaisseur commprise entre 15 et 50 µ, de Préférence 30 µ, et une largeur de un à trois milliètres.

6. Commutateur selon l'une des revendications 3 à 5, caractérisé par le fait que le diamètre d'anneau est de l'ordre de grandeur de deux à dix millimètres.

7. Commutateur selon la revendication 1 caractérisé par le fait que la bande métallique amorphe est en forme de pièce cintrée en U ou C (41, 47) dont l' ouverture (42, 48) est située du côté réponse (43, 49) du commutateur de proximité.

8. Commutateur selon la revendication 7, caractérisé par le fait que le dos (45) de la pièce cintrée (41) est situé dans le tore de bobines (21).

9. Commutateur selon la revendication 7 ou 8, caractérisé par le fait que la largeur d'ouverture (42) de la pièce centrée est à peu près égale ou inférieure à la dimension axiale (46) du tore de bobines (21).

10. Commutateur selon la revendication 9, caractérisé par le fait que la pièce cintrée (41) est cintrée en forme d'anneau et la largeur (42) de l'ouverture est à peu près égale ou inférieure au rayon (r) de la pièce cintrée (41) .

11. Commutateur selon la revendication 10, caractérisé par le fait que le rayon (r) est d'environ trois millimètres et la largeur de l'ouverture (42) d'environ 2,5 millimètres.

12. Commutateur selon la revendication 7, caractérisé par le fait que le dos (50) de la pièce cintrée (47) est située du côté frontal du tore de bobines (21) opposé au côté réponse (49) et la pièce centrée (47) enserre par ses branches latérales (51, 52) une moitié de tore (53).
